# EUROPEAN PATENT APPLICATION

(11) **EP 4 750 258 A1**
(43) Date of publication of application: **27.05.2026**
(21) Application number: 25171133.9
(22) Date of filing: 17.04.2025
(51) Int. Cl.: H10D 62/17, H10D 64/23, H10D 12/01, H10D 12/00, H10D 84/00, H10D 64/00, H10D 62/10

(54) **INSULATED GATE BIPOLAR TRANSISTOR DESIGN AND METHODS**

(30) Priority: 22.11.2024 US 202418957308
(71) Applicant: Semiconductor Components Industries, LLC, Scottsdale, AZ 85250 (US)
(72) Inventor: LIU, Mingjiao, Gilbert, AZ, 85295 (US); VENKATRAMAN, Prasad, Gilbert, AZ, 85295 (US); REXER, Christopher Lawrence, Scottsdale, AZ, 85259 (US); BRIGGS, David Kent, Phoenix, AZ, 85013 (US); KHAN, Shamsul Arefin, Chandler, AZ, 85225 (US); YEDINAK, Joseph Andrew, Mountain Top, PA, 18707 (US)
(74) Representative: Manitz Finsterwald Patent- und Rechtsanwaltspartnerschaft mbB

(57) **Abstract**

An insulated gate bipolar transistor includes multiple semiconductor layers, a trench material, an electrically insulative layer, and an emitter conductive layer. The semiconductor layers have (i) a semiconductor surface and (ii) multiple gate trenches and multiple emitter trenches separated by multiple mesas formed through the semiconductor surface. The trench material is disposed in the emitter trenches. The electrically insulative layer is formed over the semiconductor layers. The electrically insulative layer defines multiple openings that align with the mesas and extend across the emitter trenches. The electrically insulative layer do not extend into the emitter trenches. The emitter conductive layer is formed over the electrically insulative layer. The emitter conductive layer directly contacts through the openings (i) each mesa and (ii) the trench material in each emitter trench. The emitter conductive also extends across the emitter trenches.

## Description

### INTRODUCTION

High-voltage Insulated Gate Bipolar Transistors (IGBT) are used in medium to high power electronic systems, like in industrial drives, uninterruptible power supplies (UPS), renewables, electric cars, and traction motors. Progress in increased power densities has been achieved by reducing on-state and switching losses, increasing current densities, and maximum junction temperatures. As wide band gap (WBG) semiconductors such as Gallium Nitride (GaN) and Silicon Carbide (SiC) gain favor in the power semiconductor market, IGBT designs are being considered as possible competition to the WBG solutions.

Accordingly, those skilled in the art continue with research and development efforts in the field of silicon-based field-stop insulated gate bipolar transistors with narrow mesas.

### SUMMARY

An insulated gate bipolar transistor (IGBT) is provided herein. The IGBT includes multiple semiconductor layers that have a semiconductor surface. Multiple gate trenches and multiple emitter trenches are formed through the semiconductor surface A trench material is disposed in the trenches. Mesas separate the gate trenches and the emitter trenches. An electrically insulative layer is formed over the semiconductor layers. The electrically insulative layer defines multiple openings that align with the mesas and extend across the emitter trenches. The electrically insulative layer does not extend into the emitter trenches. An emitter conductive layer is formed over the electrically insulative layer. The emitter conductive layer directly contacts each of the mesas and the trench material in each of the emitter trenches. The emitter conductive layer also extends across the emitter trenches.

The above summary is not intended to represent every embodiment or aspect of the present disclosure. Rather, the foregoing summary exemplifies certain novel aspects and features as set forth herein. The above noted and other features and advantages of the present disclosure will be readily apparent from the following detailed description of representative embodiments and modes for carrying out the present disclosure when taken in connection with the accompanying drawings and the appended claims.

### BRIEF DESCRIPTION OF THE DRAWINGS

The drawings described herein are for illustrative purposes only, are schematic in nature, and are intended to be exemplary rather than to limit the scope of the disclosure.
FIG. 1 is a schematic perspective cross-section diagram of an insulated gate bipolar transistor (IGBT) in accordance with one or more exemplary embodiments.
FIG. 2 is a schematic plan diagram of another IGBT in accordance with one or more exemplary embodiments.
FIG. 3 is a schematic perspective cross-section diagram of the IGBT with additional layers in accordance with one or more exemplary embodiments.
FIG. 4 is an electrical schematic diagram of the IGBT in accordance with one or more exemplary embodiments
FIG. 5 is a schematic perspective cross-section diagram of another IGBT in accordance with one or more exemplary embodiments.
FIG. 6 is a schematic perspective cross-section diagram of still another IGBT in accordance with one or more exemplary embodiments.
FIG. 7 is a schematic perspective cross-section diagram of yet another IGBT in accordance with one or more exemplary embodiments.
FIG. 8 is a schematic cross-sectional diagram of starting semiconductor material for fabricating the IGBT in accordance with one or more exemplary embodiments.
FIG. 9 is a schematic cross-sectional diagram of fabricating trenches and trench material in the IGBT in accordance with one or more exemplary embodiments.
FIG. 10 is a schematic cross-sectional diagram of fabricating depositions into mesas in the IGBT in accordance with one or more exemplary embodiments.
FIG. 11 is a schematic cross-sectional diagram of fabricating additional trenches in the IGBT in in accordance with one or more exemplary embodiments.
FIG. 12 is a schematic cross-sectional diagram of fabricating an electrically insulative layer and an emitter conductive layer in the IGBT in accordance with one or more exemplary embodiments.

The present disclosure may be modified or embodied in alternative forms, with representative embodiments shown in the drawings and described in detail below. Inventive aspects of the present disclosure are not limited to the disclosed embodiments. Rather, the present disclosure is intended to cover alternatives falling within the scope of the disclosure as defined by the appended claims.

### DETAILED DESCRIPTION

Embodiments of the disclosure generally provide silicon-based field-stop (FS) insulated gate bipolar transistor (IGBT) designs and fabrication methods. The designs and/or methods reduce a distance between gate trenches and emitter trenches formed into a semiconductor substrate. The reduced distances are comparable with a thickness of an inversion layer. The inversion layer may reside in a high-concentration n-type (n⁺) semiconductor that also serves as a hole barrier. The trenches are separated by very narrow mesas (e.g., no wider than 0.5 micrometers (um) apart). Contacts to the narrow mesas are provided across the emitter trenches. Dry etching with accurate alignment may achieve such mesas and contacts. The resulting structures generally achieve a high injection effect and a high conduction modulation in an IGBT drift region. The structure may also produce a low forward drop in the IGBT.

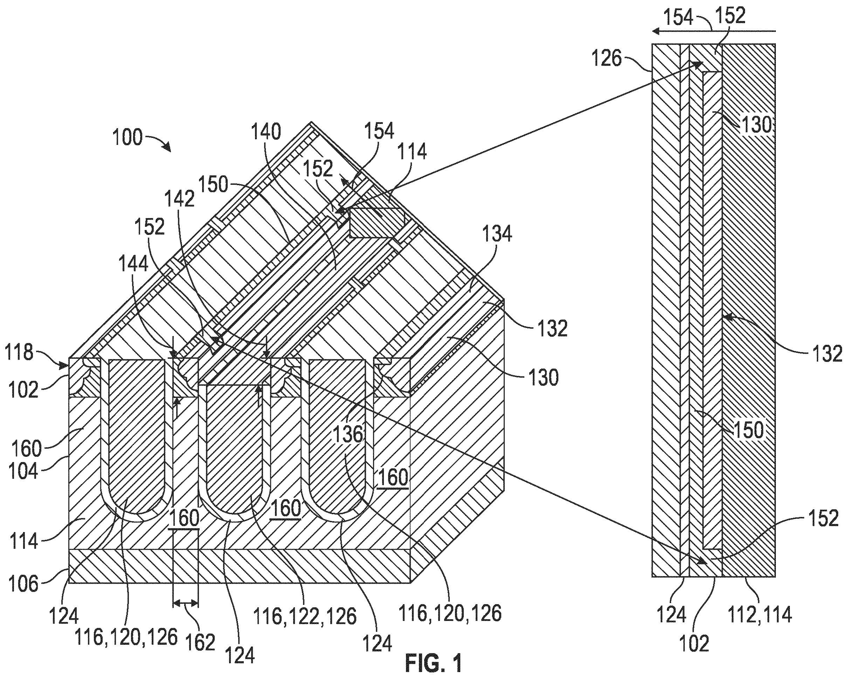

Referring to FIG. 1, a schematic perspective cross-section diagram of an example implementation of an insulated gate bipolar transistor (IGBT) 100 is shown in accordance with one or more exemplary embodiments. The IGBT 100 generally includes multiple semiconductor layers including at least a first doped layer 102 (or "first layer" for short), a second doped layer 104 (or "second layer" for short), and a third doped layer 106 (or "third layer" for short). Multiple electrically conductive layers (one shown) 112 are used to interconnect features of the IGBT 100.

In various embodiments, the first doped layer 102 may initially be fabricated as a low-doped semiconductor layer or an intrinsic semiconductor layer. During subsequent fabrication steps, the first doped layer 102 may become lightly doped as a p⁻ layer or doped as a p layer. In some embodiments, the first doped layer 102 may be formed as a p-well layer within the second doped layer 104.

The second doped layer 104 may be a lightly doped n⁻ layer. The second doped layer 104 may provide a drift region of the IGBT 100. In various embodiments, the second doped layer 104 may be formed as an epitaxial layer on the third doped layer 106.

The third doped layer 106 may be a heavily doped n⁺ layer. The third doped layer 106 may initially be a semiconductor wafer. The wafer is generally a silicon wafer.

The electrically conductive layers 112 may be formed of one or more metals and/or other electrically conductive materials. The electrically conductive layers 112 may include an emitter conductive layer 114. The emitter conductive layer 114 may be a metal (e.g., aluminum, gold, or other conductive metal), a polysilicon layer, or other conductive material.

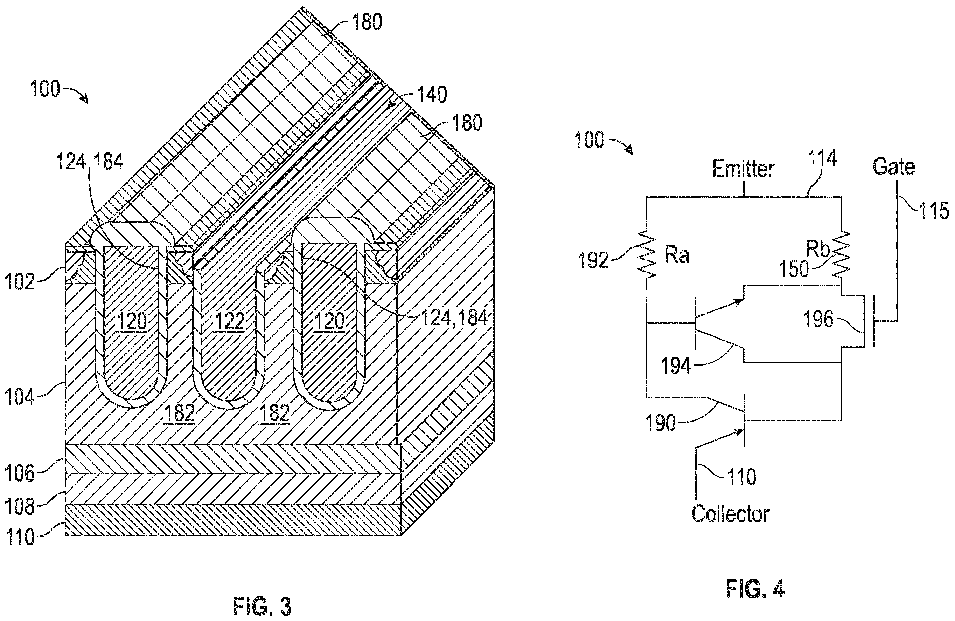

Multiple trenches 116 are formed through the first doped layer 102 and into the second doped layer 104 extending from a semiconductor surface 118 toward the third doped layer 106. Some of the trenches 116 form gate trenches 120 for the gates of the IGBT 100. Other trenches 116 form emitter trenches 122 for the emitters of the IGBT 100. A collector conductive layer 110 and a fourth doped layer 108 (see FIG. 3) may be formed in contact with the third doped layer 106. The collector conductive layer 110 generally forms the collector of the IGBT 100.

Each trench 116 has an inner wall that is coated/layered with an electrically insulative coating/layer 124. The electrically insulative coating/layer (or insulating sidewall) 124 may be silicon dioxide (SiO₂). The electrically insulative coating/layer 124 provides electrical isolation between the gate trenches 120 and the emitter trenches 122 from the surrounding first doped layer 102 and the second doped layer 104. Other electrically insulating materials may be used to meet the design criteria of a particular application.

Each trench 116 is filed with a trench material 126. The trench material 126 may be an electrical conductor, a metal, a doped polysilicon material, and/or the like.

A combination of the gate trenches 120 and the emitter trenches 122 form the mesas 160 therebetween. In various embodiments, each mesa 160 may have a narrow width 162 that is no greater than 0.5 um. Since the emitter conductive layer 114 is deposited on the mesas 160, in additional trenches 140, and stretches over the emitter trenches 122, each mesa 160 makes contact to the emitter conductive layer 114 (e.g., no "floating" mesas).

Angled trench sidewall implanted regions 130 are formed in the first doped layer 102 within the mesas 160. The angled trench sidewall implanted regions 130 generally include a first side 132 that is adjacent to the emitter trenches 122. A second side 134 of the angled trench sidewall implanted regions 130 may be parallel to and aligned with the semiconductor surface 118. A third side 136 of the angled trench sidewall implanted regions 130 joins the first side 132 and the second side 134. In various embodiments, the angled trench sidewall implanted regions 130 may be fabricated by ion implantation into the first doped layer 102 of the mesas 160. The resulting angled trench sidewall implanted regions 130 may be implanted as heavily doped p⁺ regions.

The additional trenches 140 (one shown) are formed over the emitter trenches 122 and extend from the semiconductor surface 118 toward the second doped layer 104. A trench depth 142 of the additional trenches 140 may be less than a thickness (or well depth) 144 of the first doped layer 102.

In various embodiments, optional ballast resistors 150 may be formed in the first doped layer 102. The ballast resistors 150 generally overlap the angled trench sidewall implanted regions 130. As illustrated, ballast contacts 152 of the ballast resistors 150 may be exposed at trench sidewalls of the trenches 116. The trench sidewalls are the interfaces between the trenches 116 and the adjacent mesas 160. In various embodiments, the ballast resistors 150 may extend beyond the angled trench sidewall implanted regions 130 toward the gate trenches 120. In some embodiments, the ballast resistors 150 may be fabricated by ion implantation into the first doped layer 102 and the angled trench sidewall implanted regions 130 through the semiconductor surface 118. In other embodiments, the ballast resistors 150 may be fabricated by diffusion into the first doped layer 102. The resulting ballast resistors 150 may be implanted as heavily doped n⁺ regions. Therefore, the IGBT 100 may include a structure of n⁺ regions (e.g., 150) overlapping p⁺ regions (e.g., 130) as viewed top to bottom in the figure.

Ballast contacts 152 are formed at both ends of each ballast resistor 150. The ballast contacts 152 are also fabricated by ion implantation or diffusion into the angled trench sidewall implanted regions 130 through the semiconductor surface 118. The ballast contacts 152 may be implemented as heavily doped n⁺ regions. In some designs, the ballast contacts 152 extend through the angled trench sidewall implanted regions 130 (left and right as illustrated) and are exposed at the sidewalls of the mesas 160 into the additional trenches 140. In other designs, the ballast contacts 152 do not extend to the trench sidewalls the additional trenches 140.

To aid in understanding the structure of the IGBT 100, a portion of the device as seen along an arrow 154 at the semiconductor surface 118 is shown in the right side of the figure. Following the arrow 154 from right to left in the figure illustrates the emitter conductive layer 114 abutting the first side 132 of an angled trench sidewall implanted region 130 and the ballast contacts 152. The ballast resistor 150 is seen between the angled trench sidewall implanted region 130 and the electrically insulative coating/layer 124 (e.g., a gate oxide) adjoining the trench material 126 (e.g., a gate polysilicon material).

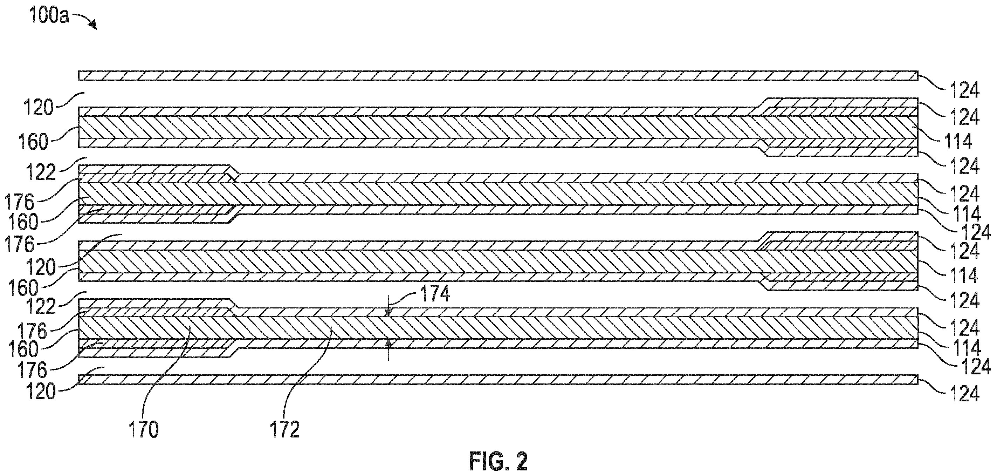

Referring to FIG. 2, a schematic plan diagram of an example implementation of another IGBT 100a is shown in accordance with one or more exemplary embodiments. The IGBT 100a may be a variation of the IGBT 100. The figure illustrates a design in which the trenches alternate between gate trenches 120 and emitter trenches 122. In other designs, a sequence of trenches may be gate trench 120, emitter trench 122, emitter trench 122, gate trench, emitter trench 122, and the like. Other sequences and numbers of the trenches may be implemented to meet the design criteria of a particular application.

The mesas 160 may include a wide portion 170 and a narrow portion 172. The narrow portions 172 may be no greater than 0.5 um wide. The wide portions 170 may be approximately 0.7 to 1.0 um wide. Other dimensions of the wide portions 170 may be implemented to meet the design criteria of a particular application.

The emitter conductive layers 114 are created on each mesa 160. A width 174 of the emitter conductive layers 114 may be consistent across the mesas 160.

In various embodiments, emitter conductive layers 114 do not overlap the electrically insulative coating/layer 124 (as illustrated in FIG. 2). Therefore, n⁺ regions 176 may exist in the wide portions 170 between the emitter conductive layers 114 and the electrically insulative coating/layer 124.

Referring to FIG. 3, a schematic perspective cross-section diagram of the insulated gate bipolar transistor 100 with additional layers is shown in accordance with one or more exemplary embodiments. A fourth doped layer 108 (or "fourth layer" for short) may be deposited or formed on the backside of the third doped layer 106. The fourth doped layer 108 may be created either through deposition or implantation. The fourth doped layer 108 may be a heavily doped p⁺ layer.

A collector conductive layer 110 is formed in contact with the fourth doped layer 108. The collector conductive layer 110 is generally a metal (e.g., aluminum, gold, or other conductive metal), a polysilicon layer, or other conductive material. The collector conductive layer 110 forms the collector node of the IGBT 100.

An electrically insulative layer 180 is formed of an insulator, such as borophosphosilicate glass (BPSG) or thick silicon dioxide, over the gate trenches 120. Other electrically insulative materials may be utilized to meet the design criteria of a particular application. In various embodiments, electrically insulative layer 180 extends over the gate trenches 120 and may extend partially (as illustrated) or completely over the first doped layer 102 to an edge of (but not into) the additional trenches 140.

Drift regions 182 exist in the second doped layer 104 between the gate trenches 120 and the emitter trenches 122. The electrically insulative coating/layer 124 adjoining the gate trenches 120 in the first doped layer 102 act as gate oxides 184. While the gates are positively biased, inversion layers are formed near the gate oxides 184 in the first doped layer 102. The inversion layers act as a barrier to holes and enhances the conduction modulation of electrons in the drift regions 182. As such, the insulated gate bipolar transistor 100 is characterized by a lack of hole storage regions under the first doped well layer 102 in the mesas 160. The electrons are introduced into the drift regions 182 from the collector conductive layer 110. A plasma concentration under the trenches 116 is generally higher for narrow mesa (e.g., < 0.5 um) designs than that of wider mesa (e.g., > 0.7 um) designs during an on-state of the transistor, that reduces the conduction loss.

Referring to FIG. 4, an electrical schematic diagram of the IGBT 100 is shown in accordance with one or more exemplary embodiments. A first (PNP) transistor 190 and a series resistance 192 (Ra) are created by the layers 102-108 between the collector conductive layer 110 and the emitter conductive layer 114. A second (NPN) transistor 194 and the ballast resistor 150 are formed between a base of the first transistor 190 and the emitter conductive layer 114 (emitter node of the IGBT). A base of the second transistor 194 is connected to the collector of the first transistor 190. A third metal oxide semiconductor (MOS) transistor 196 is formed between the ballast resistor 150 and the base of the first transistor 190. A gate of the third transistor 196 is the gate node 115 of the IGBT 100.

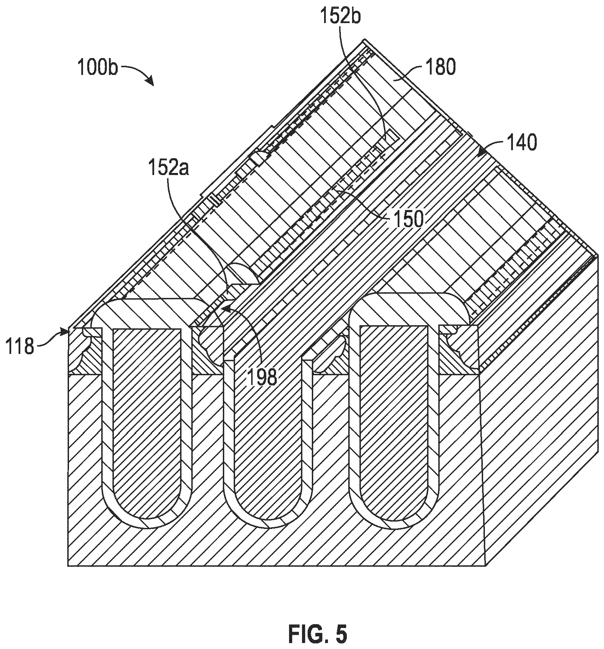

Referring to FIG. 5, a schematic perspective cross-section diagram of an example implementation of an IGBT 100b is shown in accordance with one or more exemplary embodiments. The IGBT 100b may be a variation of the IGBT 100 shown in FIG. 1 and/or the IGBT 100a shown in FIG. 2. The IGBT 100b generally illustrates a first ballast resistor contact option.

The electrically insulative layer 180 of the IGBT 100b is etched to open a via 198 (or additional opening) to a ballast contact 152a at one end of the ballast resistors 150 to provide electrical contact to the emitter conductive layer 114 (see FIG. 1) along the semiconductor surface 118. The other ballast contact 152b at the other end of the ballast resistor 150 is buried beneath the electrically insulative layer 180 and provides electrical contact to the first doped layer 102. A size of the ballast contact 152a generally does not extend to the trench sidewall of the additional trench 140.

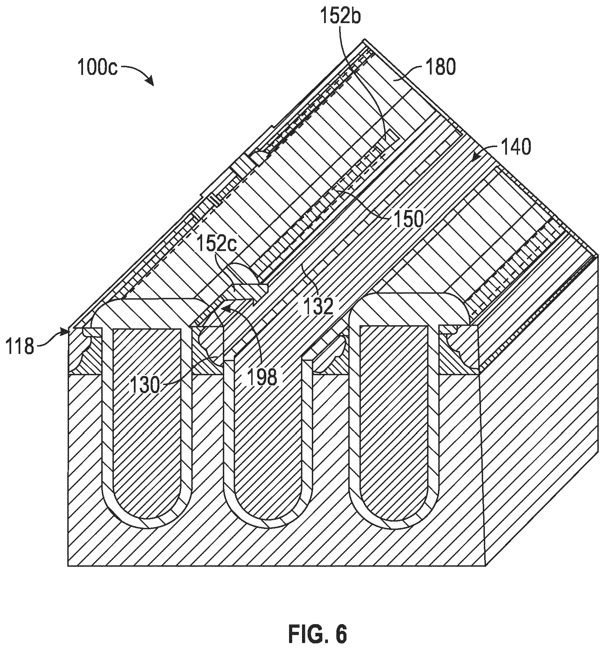

Referring to FIG. 6, a schematic perspective cross-section diagram of an example implementation of an insulated gate bipolar transistor (IGBT) 100c is shown in accordance with one or more exemplary embodiments. The IGBT 100c may be a variation of the IGBT 100, the IGBT 100a, and/or the IGBT 100b. The IGBT 100c generally illustrates a second ballast resistor contact option.

The electrically insulative layer 180 of the IGBT 100c is etched to open the via/additional opening 198 to a ballast contact 152c at one end of the ballast resistors 150 to provide electrical contact to the emitter conductive layer 114 (see FIG. 1) along the semiconductor surface 118 and at the first side 132 of the angled trench sidewall implanted region 130. The other ballast contact 152b at the other end of the ballast resistor 150 is buried beneath the electrically insulative layer 180 and provides electrical contact to the first doped layer 102. A size of the ballast contact 152c generally extends to the trench sidewall of the additional trench 140.

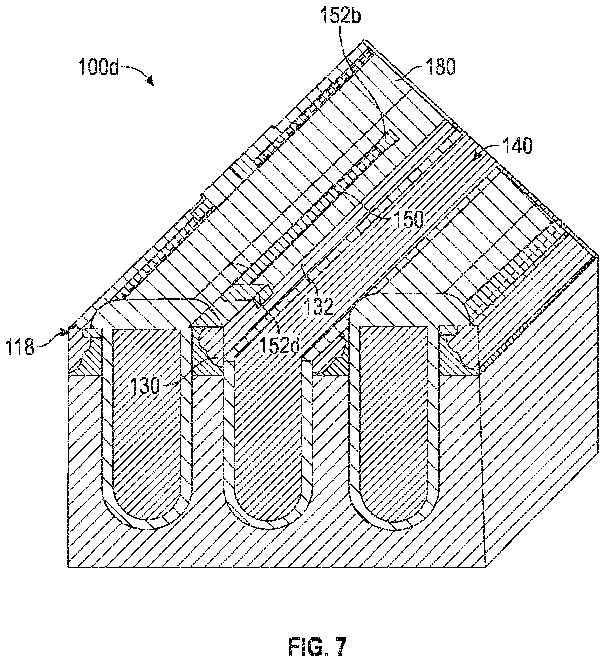

Referring to FIG. 7, a schematic perspective cross-section diagram of an example implementation of an insulated gate bipolar transistor (IGBT) 100d is shown in accordance with one or more exemplary embodiments. The IGBT 100d may be a variation of the IGBT 100, the IGBT 100a, the IGBT 100b, and/or the IGBT 100c. The IGBT 100d generally illustrates a third ballast resistor contact option.

The electrically insulative layer 180 of the IGBT 100d covers a ballast contact 152d outside the additional trench 140 at one end of the ballast resistors 150. The emitter conductive layer 114 (see FIG. 1) directly contacts the ballast contact 152d at the first side 132 of the angled trench sidewall implanted region 130. The other ballast contact 152b at the other end of the ballast resistor 150 is buried beneath the electrically insulative layer 180 and provides electrical contact to the first doped layer 102.

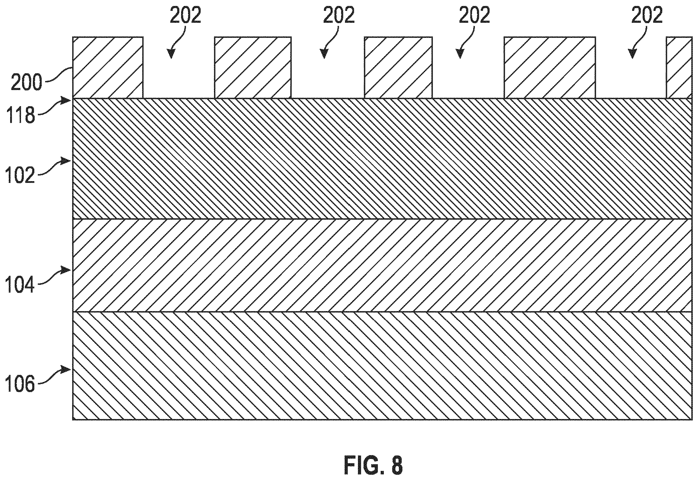

Referring to FIGS. 8-12, schematic cross-sectional diagrams of an example method of fabricating the IGBT 100 is shown in accordance with one or more exemplary embodiments. The sequence of steps are shown as a representative example. Other step orders may be implemented to meet the criteria of a particular application.

Referring to FIG. 8, a schematic cross-sectional diagram of the starting semiconductor material for fabricating the IGBT 100 is shown in accordance with one or more exemplary embodiments.

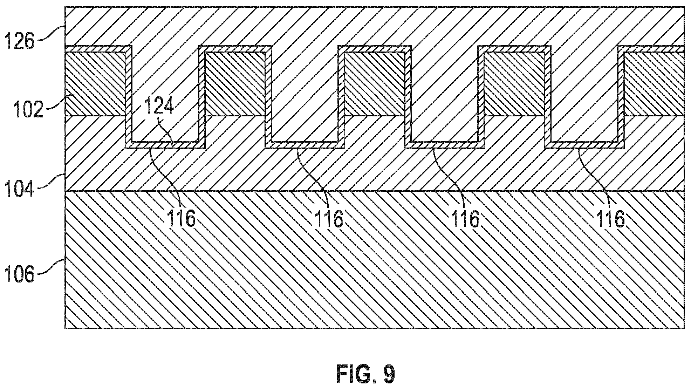

The doped layers 102, 104, and 106, are initially formed in a stacked/layered configuration with an oxide mask layer 200 coupled with first doped layer 102 at the semiconductor surface 118. Note that the first doped layer 102 may not begin as a p⁻ semiconductor layer, but may be altered later in the fabrication to be a lightly-doped p⁻ or a p doped semiconductor layer. The oxide mask layer 200 is subsequently patterned to form vias 202 over the trenches 116 (see FIG. 9).

Referring to FIG. 9, a schematic cross-sectional diagram of The IGBT with the trenches and trench material is shown in accordance with one or more exemplary embodiments.

The trenches 116 are formed by etching into the first doped layer 102 through the patterns in the oxide mask layer 200 (FIG. 8). The etching may be achieved by dry etching with accurate alignment to produce the narrow mesas. The oxide mask layer 200 may then be removed and the electrically insulative coating/layer 124 is grown. Thereafter, the trench material 126 is deposited to fill the trenches 116.

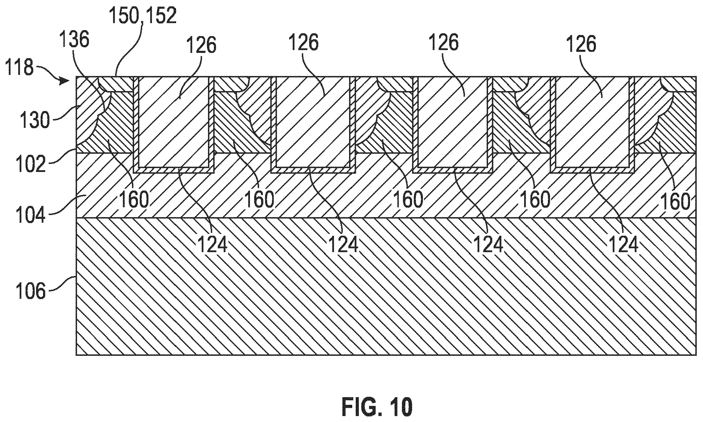

Referring to FIG. 10, a schematic cross-sectional diagram of the depositions in the mesas is shown in accordance with one or more exemplary embodiments.

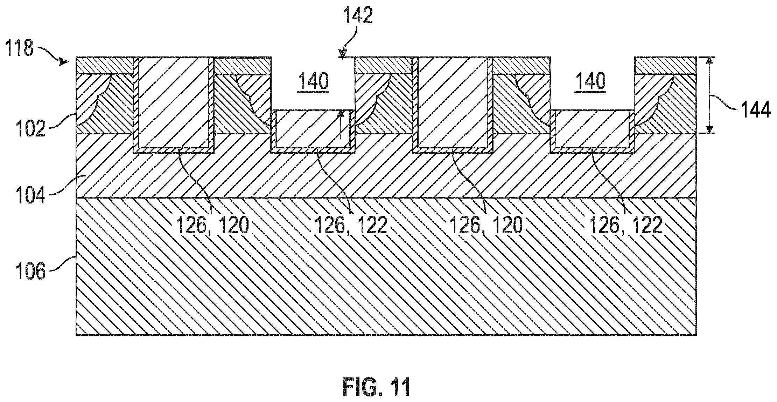

After the excess trench material 126 has been removed, the angled trench sidewall implanted regions 130, the optional ballast resistors 150, and the optional ballast contacts 152 may be formed on the mesas 160. In various embodiments, the ballast resistors 150 and the ballast contacts 152 may be formed using ion implantation or diffusion through the semiconductor surface 118. In embodiments without the ballast resistors 150, a contact layer 153 (see FIG. 11) may be formed on the mesas 160. The contact layer 153 may be an n⁺ layer. Thereafter, a mask is provided over the n-doped areas and the angled trench sidewall implanted regions 130 are fabricated using ion implantation to achieve the angled third side 136. In other embodiments, the angled trench sidewall implanted regions 130 are fabricated first. A mask is subsequently provided over the angled trench sidewall implanted regions 130, then the ballast resistors 150 and the ballast contacts 152, or the n⁺ contact layers 153 are created using a high dose of phosphorus or arsenic to generate the n⁺ structures.

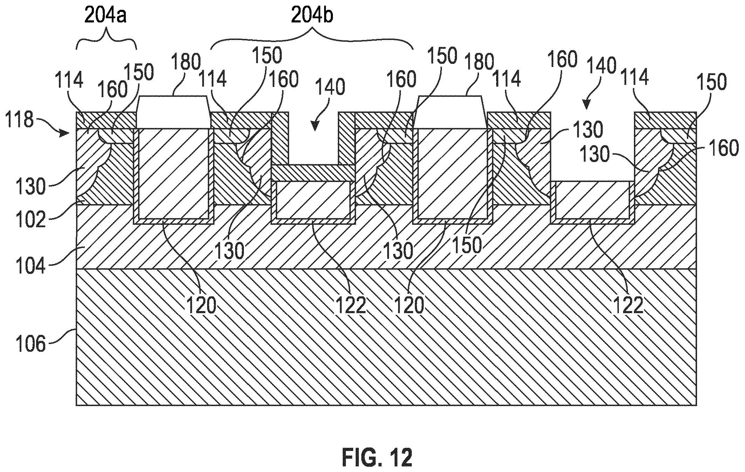

Referring to FIG. 11, a schematic cross-sectional diagram of the additional trenches is shown in accordance with one or more exemplary embodiments. FIG. 11 generally illustrates an implementation with the n⁺ contact layers 153 and without the ballast resistors 150 and the ballast contacts 152. The n⁺ contact layers 153 and the p⁺ angled trench sidewall implanted regions 130 contact the emitter conductive layer 114 (see FIG. 12) through an inward side 141 of the additional trenches 140. In various embodiments, a top side of the n⁺ contact layers 153 may be covered by an insulator (not shown).

A mask may be used to define the additional trenches 140 in alignment with the emitter trenches 122. The dry etching may be used to remove some of the trench material 126 from the emitter trenches 122. The additional trenches 140 may be below the semiconductor surface 118 to the trench depth 142 (see FIG. 1). The trench depth 142 of each additional trench 140 is shallower than a well depth 144 of the first doped p-well layer 102. The trench material 126 in the gate trenches 120 may be unchanged by the formation of the additional trenches 140.

Referring to FIG. 12, a schematic cross-sectional diagram of the electrically insulative layer and the emitter conductive layer is shown in accordance with one or more exemplary embodiments.

The electrically insulative layer 180 (see FIG.1) is generally formed over the semiconductor surface 118. In some embodiments, the electrically insulative layer 180 may be patterned to create openings 204a over the mesas 160 thereby allowing full contact of the emitter conductive layer 114 along the mesas 160 (see FIG. 2). In other embodiments, the electrically insulative layer 180 may be patterned to create opening 204b over the mesas 160 and the additional trenches 140 thereby allowing contact of the emitter conductive layer 114 along the mesas 160 and the first side 132 of the angled trench sidewall implanted regions 130. Such emitter conducive layers 114 extend across the emitter trenches 122. In still other embodiments, the electrically insulative layer 180 may be patterned to open over the additional trenches 140 and portions of the mesas 160. In such embodiments, the angled trench sidewall implanted regions 130 and the ballast resistors 150 may be covered by the electrically insulative layer 180 and contact to the angled trench sidewall implanted regions 130 and the ballast resistors 150 is achieved through the interior walls of the additional trench 140.

Clause 1: The above-described insulated gate bipolar transistor, comprising: a plurality of semiconductor layers that has (i) a semiconductor surface and (ii) a plurality of gate trenches and a plurality of emitter trenches separated by a plurality of mesas formed through the semiconductor surface; a trench material disposed in the plurality of emitter trenches; an electrically insulative layer formed over the plurality of semiconductor layers, wherein the electrically insulative layer (i) defines a plurality of openings that align with the plurality of mesas and extend across the plurality of emitter trenches and (ii) does not extend into the plurality of emitter trenches; and an emitter conductive layer formed over the electrically insulative layer, wherein the emitter conductive layer: directly contacts through the plurality of openings (i) each of the plurality of mesas and (ii) the trench material in each of the plurality of emitter trenches; and extends across the plurality of emitter trenches.

Clause 2: The insulated gate bipolar transistor according to clause 1, further comprising: a first doped layer formed through the semiconductor surface on each of the plurality of mesas; and a second doped layer formed overlapping each of the first doped layers, wherein the emitter conductive layer directly contacts each of the first doped layers and the second doped layers on the plurality of mesas through the plurality of openings.

Clause 3: The insulated gate bipolar transistor according to clause 2, further comprising: a plurality of insulating sidewalls around the plurality of emitter trenches; and a plurality of angled trench sidewall implanted regions formed (i) through the semiconductor surface into the first doped layers and (ii) adjoining the plurality of insulating sidewalls.

Clause 4: The insulated gate bipolar transistor according to any of clauses 1 to 3, wherein the plurality of semiconductor layers includes: a well layer that has a well depth; and a plurality of additional trenches formed through the semiconductor surface into the well layer and aligned the plurality of emitter trenches.

Clause 5: The insulated gate bipolar transistor according to clause 4, wherein: a trench depth of each of the plurality of additional trenches is shallower than the well depth of the well layer; and the plurality of additional trenches expose a plurality of first sidewalls of the plurality of angled trench sidewall implanted regions.

Clause 6: The insulated gate bipolar transistor according to clause 5, wherein the emitter conductive layer directly contacts the plurality of first sidewalls of the plurality of angled trench sidewall implanted regions through the plurality of additional openings.

Clause 7: The insulated gate bipolar transistor according to clause 6, further comprising: a plurality of ballast resistors formed in the second doped layer of the plurality of mesas, wherein: the plurality of ballast resistors include a plurality of ballast contacts formed in the plurality of angled trench sidewall implanted regions; the plurality of ballast contacts are separated from the plurality of first sidewalls of the plurality of angled trench sidewall implanted regions; and the emitter conductive layer directly contacts the plurality of ballast contacts through the plurality of openings.

Clause 8: The insulated gate bipolar transistor according to clause 6, further comprising: a plurality of ballast resistors formed in the second doped layer of the plurality of mesas, wherein: the plurality of ballast resistors include a plurality of ballast contacts formed in the plurality of angled trench sidewall implanted regions; the plurality of ballast contacts are exposed at the plurality of first sidewalls of the plurality of angled trench sidewall implanted regions; and the emitter conductive layer directly contacts the plurality of ballast contacts and at the plurality of first sidewalls through the plurality of openings.

Clause 9: The insulated gate bipolar transistor according to clause 6, further comprising: a plurality of ballast resistors formed in the second doped layer of the plurality of mesas, wherein: the plurality of ballast resistors include a plurality of ballast contacts formed in the plurality of angled trench sidewall implanted regions; the plurality of ballast contacts are exposed at the plurality of first sidewalls of the plurality of angled trench sidewall implanted regions; the electrically insulative layer covers the plurality of ballast contacts outside the plurality of additional trenches; and the emitter conductive layer directly contacts the plurality of ballast contacts at the plurality of first sidewalls.

Clause 10.: The insulated gate bipolar transistor according to clause 9, wherein the emitter conductive layer directly connects to the plurality of angled trench sidewall implanted regions to the plurality of ballast contacts.

Clause 11: The insulated gate bipolar transistor according to clause 9, wherein a subset of the plurality of ballast contacts are electrically connected to the first doped layer.

Clause 12: The insulated gate bipolar transistor according to clause 4, wherein the insulated gate bipolar transistor is characterized by a lack of a plurality of hole storage regions under the well layer in the plurality of mesas.

Clause 13: The insulated gate bipolar transistor according to any of clauses 1 to 3, wherein a width of each of the plurality of mesas is no greater than 0.5 micrometers.

Clause 14: An insulated gate bipolar transistor, comprising: a plurality of semiconductor layers that has (i) a semiconductor surface and (ii) a plurality of gate trenches and a plurality of emitter trenches separated by a plurality of mesas formed through the semiconductor surface; a trench material disposed in the plurality of emitter trenches; a first doped layer formed through the semiconductor surface on each of the plurality of mesas; a second doped layer formed overlapping each of the first doped layers; an electrically insulative layer formed over the plurality of semiconductor layers, wherein the electrically insulative layer (i) defines a plurality of openings that align with the plurality of mesas and extend across the plurality of emitter trenches and (ii) does not extend into the plurality of emitter trenches; and an emitter conductive layer formed over the electrically insulative layer, wherein the emitter conductive layer directly contacts through the plurality of openings (i) each of the second doped layers and (ii) the trench material in each of the plurality of emitter trenches.

Clause 15: The insulated gate bipolar transistor according to clause 14, further comprising: a plurality of insulating sidewalls around the plurality of emitter trenches; and a plurality of angled trench sidewall implanted regions formed (i) through the semiconductor surface into the first doped layers and (ii) adjoining the plurality of insulating sidewalls.

Clause 16: The insulated gate bipolar transistor according to clause 14 or 15, wherein the plurality of semiconductor layers includes: a well layer that has a well depth; and a plurality of additional trenches formed through the semiconductor surface into the well layer and aligned the plurality of emitter trenches.

Clause 17: The insulated gate bipolar transistor according to clause 16, wherein: a trench depth of each of the plurality of additional trenches is shallower than the well depth of the well layer; and the plurality of additional trenches expose a plurality of first sidewalls of the plurality of angled trench sidewall implanted regions.

Clause 18: The insulated gate bipolar transistor according to clause 17, wherein the emitter conductive layer directly contacts the plurality of first sidewalls of the plurality of angled trench sidewall implanted regions through the plurality of openings.

Clause 19: The insulated gate bipolar transistor according to clause 14 or 15, wherein a width of each of the plurality of mesas is no greater than 0.5 micrometers.

Clause 20: A method for fabricating an insulated gate bipolar transistor comprising: forming a plurality of semiconductor layers that has a semiconductor surface; forming a plurality of gate trenches and a plurality of emitter trenches separated by a plurality of mesas through the semiconductor surface of the plurality of semiconductor layers; filling the plurality of emitter trenches with a trench material; forming an electrically insulative layer over the plurality of semiconductor layers, wherein the electrically insulative layer (i) defines a plurality of openings that align with the plurality of mesas and extend across the plurality of emitter trenches and (ii) does not extend into the plurality of emitter trenches; and forming an emitter conductive layer over the electrically insulative layer, wherein the emitter conductive layer: directly contacts through the plurality of openings (i) each of the plurality of mesas and (ii) the trench material in each of the plurality of emitter trenches; and extends across the plurality of emitter trenches.

These and other benefits of the present teachings will be readily appreciated by those skilled in the art now having the benefit of the foregoing disclosure. While several modes for carrying out the many aspects of the present teachings have been described in detail, those familiar with the art to which these teachings relate will recognize various alternative aspects for practicing the present teachings that are within the scope of the appended claims. The above description and accompanying drawings are illustrative and exemplary of the entire range of alternative embodiments that an ordinarily skilled artisan would recognize as implied by, structurally and/or functionally equivalent to, or otherwise rendered obvious based upon the included content, and not as limited solely to those explicitly depicted and/or described embodiments. Moreover, the present concepts expressly include combinations and sub-combinations of the described elements and features. The detailed description and the drawings are supportive and descriptive of the present teachings, with the scope of the present teachings defined solely by the claims.

## Claims

1. An insulated gate bipolar transistor, comprising:
a plurality of semiconductor layers that has (i) a semiconductor surface and (ii) a plurality of gate trenches and a plurality of emitter trenches separated by a plurality of mesas formed through the semiconductor surface;
a trench material disposed in the plurality of emitter trenches;
an electrically insulative layer formed over the plurality of semiconductor layers, wherein the electrically insulative layer (i) defines a plurality of openings that align with the plurality of mesas and extend across the plurality of emitter trenches and (ii) does not extend into the plurality of emitter trenches; and
an emitter conductive layer formed over the electrically insulative layer, wherein the emitter conductive layer:
directly contacts through the plurality of openings (i) each of the plurality of mesas and (ii) the trench material in each of the plurality of emitter trenches; and
extends across the plurality of emitter trenches.

2. The insulated gate bipolar transistor according to claim 1, further comprising:
a first doped layer formed through the semiconductor surface on each of the plurality of mesas; and
a second doped layer formed overlapping each of the first doped layers, wherein the emitter conductive layer directly contacts each of the first doped layers and the second doped layers on the plurality of mesas through the plurality of openings.

3. The insulated gate bipolar transistor according to claim 2, further comprising:
a plurality of insulating sidewalls around the plurality of emitter trenches; and
a plurality of angled trench sidewall implanted regions formed (i) through the semiconductor surface into the first doped layers and (ii) adjoining the plurality of insulating sidewalls.

4. The insulated gate bipolar transistor according to claim 3, wherein the plurality of semiconductor layers includes:
a well layer that has a well depth; and
a plurality of additional trenches formed through the semiconductor surface into the well layer and aligned the plurality of emitter trenches.

5. The insulated gate bipolar transistor according to claim 4, wherein:
a trench depth of each of the plurality of additional trenches is shallower than the well depth of the well layer; and
the plurality of additional trenches expose a plurality of first sidewalls of the plurality of angled trench sidewall implanted regions.

6. The insulated gate bipolar transistor according to claim 5, wherein the emitter conductive layer directly contacts the plurality of first sidewalls of the plurality of angled trench sidewall implanted regions through the plurality of additional openings.

7. The insulated gate bipolar transistor according to claim 6, further comprising:
a plurality of ballast resistors formed in the second doped layer of the plurality of mesas, wherein:
the plurality of ballast resistors include a plurality of ballast contacts formed in the plurality of angled trench sidewall implanted regions;
the plurality of ballast contacts are separated from the plurality of first sidewalls of the plurality of angled trench sidewall implanted regions; and
the emitter conductive layer directly contacts the plurality of ballast contacts through the plurality of openings.

8. The insulated gate bipolar transistor according to claim 6, further comprising:
a plurality of ballast resistors formed in the second doped layer of the plurality of mesas, wherein:
the plurality of ballast resistors include a plurality of ballast contacts formed in the plurality of angled trench sidewall implanted regions;
the plurality of ballast contacts are exposed at the plurality of first sidewalls of the plurality of angled trench sidewall implanted regions; and
the emitter conductive layer directly contacts the plurality of ballast contacts and at the plurality of first sidewalls through the plurality of openings.

9. The insulated gate bipolar transistor according to claim 6, further comprising:
a plurality of ballast resistors formed in the second doped layer of the plurality of mesas, wherein:
the plurality of ballast resistors include a plurality of ballast contacts formed in the plurality of angled trench sidewall implanted regions;
the plurality of ballast contacts are exposed at the plurality of first sidewalls of the plurality of angled trench sidewall implanted regions;
the electrically insulative layer covers the plurality of ballast contacts outside the plurality of additional trenches; and
the emitter conductive layer directly contacts the plurality of ballast contacts at the plurality of first sidewalls.

10. The insulated gate bipolar transistor according to claim 9, wherein the emitter conductive layer directly connects to the plurality of angled trench sidewall implanted regions to the plurality of ballast contacts.

11. The insulated gate bipolar transistor according to claim 9, wherein a subset of the plurality of ballast contacts are electrically connected to the first doped layer.

12. The insulated gate bipolar transistor according to claim 4, wherein the insulated gate bipolar transistor is **characterized by** a lack of a plurality of hole storage regions under the well layer in the plurality of mesas.

13. The insulated gate bipolar transistor according to claim 1, wherein a width of each of the plurality of mesas is no greater than 0.5 micrometers.

14. A method for fabricating an insulated gate bipolar transistor comprising:
forming a plurality of semiconductor layers that has a semiconductor surface;
forming a plurality of gate trenches and a plurality of emitter trenches separated by a plurality of mesas through the semiconductor surface of the plurality of semiconductor layers;
filling the plurality of emitter trenches with a trench material;
forming an electrically insulative layer over the plurality of semiconductor layers, wherein the electrically insulative layer (i) defines a plurality of openings that align with the plurality of mesas and extend across the plurality of emitter trenches and (ii) does not extend into the plurality of emitter trenches; and
forming an emitter conductive layer over the electrically insulative layer, wherein the emitter conductive layer:
directly contacts through the plurality of openings (i) each of the plurality of mesas and (ii) the trench material in each of the plurality of emitter trenches; and
extends across the plurality of emitter trenches.

15. The method according to claim 14, wherein a width of each of the plurality of mesas is no greater than 0.5 micrometers.
